Europäisches Patentamt

European Patent Office

Office européen des brevets

(11) Publication number: 0 380 077
A2

## (12) EUROPEAN PATENT APPLICATION

(21) Application number: 90101415.9

(22) Date of filing: 24.01.90

(51) Int. Cl.5: H01L 29/73, H01L 29/76, H01L 29/165

(30) Priority: 25.01.89 JP 13915/89
14.06.89 JP 149627/89

(43) Date of publication of application:
01.08.90 Bulletin 90/31

(84) Designated Contracting States:
DE GB NL

(71) Applicant: HITACHI, LTD.
6, Kanda Surugadai 4-chome
Chiyoda-ku, Tokyo 100(JP)

(72) Inventor: Murakami, Eiichi
Hitachi Fuchuryo
32-7, Nishifucho-3-chome, Fuchu-shi(JP)
Inventor: Nakagawa, Kiyokazu
Sayama Niu Taun 108-2
3484-145, Kashiwabare, Sayama-shi(JP)
Inventor: Ohshima, Takashi
Hitachi Fuchuryo, 32-7
Nishifucho-3-chome, Fuchu-shi(JP)
Inventor: Eto, Hiroyuki, Hitachi Daiyon
Kyoshinryo
14-6, Nishikoigakubo-4-chome
Kokubunji-shi(JP)
Inventor: Miyao, Masanobu
Shintokorozawa Sukai Haitsu 107
1188-5, Kamiarai, Tokorozawa-shi(JP)

(74) Representative: Strehl, Schübel-Hopf,
Groening
Maximilianstrasse 54 Postfach 22 14 55
D-8000 München 22(DE)

(54) Transistor provided with strained germanium layer.

(57) A transistor having a high carrier mobility and
suited for a high-speed operation can be formed by
utilizing a fact that the carrier mobility in a strained
germanium layer (2, 21) is large. A strain control
layer (31, 31A) is provided beneath the germanium
layer (2, 21) to impose a compressive strain on the
germanium layer (2, 21), and the composition of the
strain control layer (31, 31A) in a predetermined
range is used to generate the compressive strain
surely.

FIG. 2A

# TRANSISTOR PROVIDED WITH STRAINED GERMANIUM LAYER

## BACKGROUND OF THE INVENTION

The present invention relates to a semiconductor device, and more particularly to a semiconductor device having a high carrier mobility.

It has been proposed to fabricate a field effect transistor (FET) using silicon or compound semiconductive materials such as GaAs and AlGaAs in such a manner that a carrier transport channel layer is buried in a semiconductor layer. In order to form a buried channel layer, it is required to produce a potential well for confining carriers (namely, electrons or holes). As is well known, the potential well (that is, nonuniform distribution of inner potential) can be obtained by forming a heterostructure of semiconductor layers having different band structures, or by doping a semiconductor layer selectively with an impurity. An example of the buried channel due to the heterostructure is a GaAs channel layer sandwiched between GaAlAs layers which have a large band gap. In this case, electrons from doped GaAlAs layers are confined in a undoped GaAs channel layer (that is, potential well), and travel therein. Thus, a field effect transistor having such a heterostructure is usually called "double-heterostructure modulation-doped field effect transistor DH-MODFET (refer to the Japanese J. Appl. Phys. Vol. 23, No. 2, 1984, pages L61 to L63).

While, an example of the buried channel due to selective doping is an n-type impurity doped thin layer formed in silicon. In this case, a potential well is formed by dopant ions, and electrons are supplied from dopants. Thus, the thin doped layer can act as a channel layer. A field effect transistor having such a thin doped layer is usually called "doped-channel FET" (refer to the Japanese J. Appln. Phys. Vol. 26, No. 12, 1987, pages L1933 to L1936).

In the MODFET, no impurity ion is present in the channel layer. Accordingly, ionized impurity scattering does not occur, and a high carrier mobility can be obtained. While, in the doped-channel FET, the carrier concentration in the channel layer can be increased.

Further, a field effect transistor using an $Si_{0.2}Ge_{0.8}$ layer as a channel layer is disclosed on pages 308 to 310 of the IEEE Electron Device Lett., Vol. DEL-7, 1986. In this field effect transistor, as shown in Fig. 1, an $Si_{0.2}Ge_{0.8}$ channel layer 200 and a p-silicon layer 320 are successively piled on a silicon substrate 1 through heteroepitoxial growth techniques, to form a two-dimensional hole gas at a p-Si/$Si_{0.2}Ge_{0.8}$ interface. It has been confirmed that this field effect transistor operates as an MODFET.

It is to be noted that the $Si_{0.2}Ge_{0.8}$ channel layer 200 has a thickness of 25 nm which is smaller than the critical thickness of commensulate growth (that is, stained growth) of the $Si_{0.2}Ge_{0.8}$ layer for the silicon substrate 1.

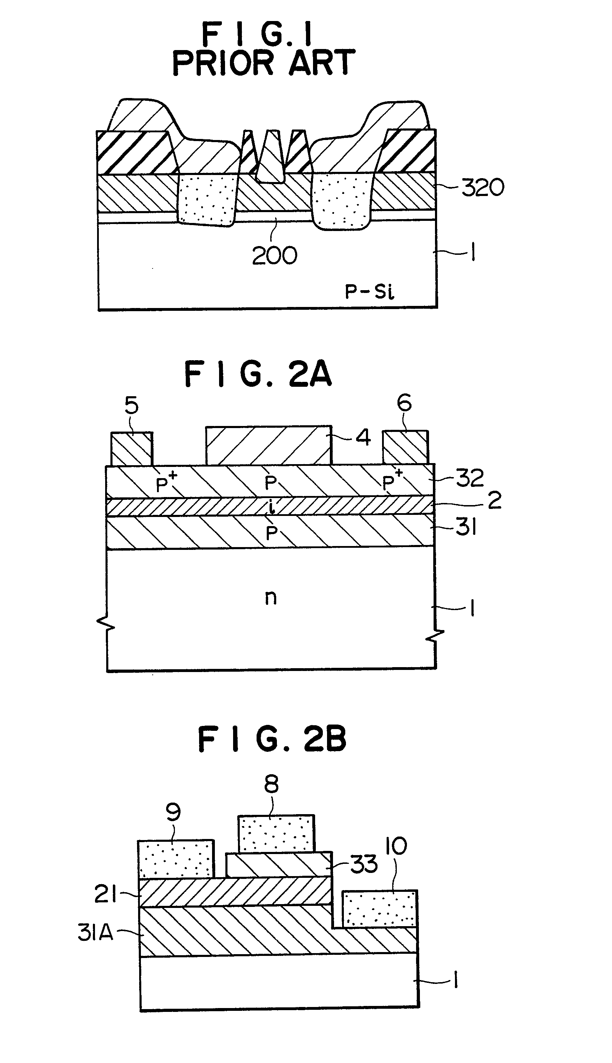

The MODFET using the GaAs layer as the channel layer, however, has a problem due to the material property of GaAs. That is, the electron mobility in GaAs is as high as 8,600 $cm^2/V \cdot sec$ at room temperature, but the hole mobility in GaAs is as low as 250 $cm^2/V \cdot sec$ at room temperature. When an n-MODFET and a p-MODFET each provided with a GaAs channel layer are fabricated to form a complementary logic circuit, the large difference in mobility between an electron and a positive hole arouses a problem. While, in the doped-channel FET, there arises a problem that the electron mobility in the channel layer is reduced by the impurity ion scattering therein by about one order of magnitude, as compared with the electron mobility in undoped silicon. In the MODFET of Fig. 1, the sheet carrier concentration in the channel layer is as low as 2.5 x $10^{11}$ $cm^{-2}$, and the transconductance $g_m$ is as low as 2.5 mS/mm. This is because the band discontinuity $\Delta E_V$ at the $Si/Si_{0.8}Ge_{0.2}$ interface is as small as 0.15 eV, and thus it is impossible to confine a sufficiently large number of positive holes in the potential well. In order to improve the characteristics of this MODFET, it is necessary to make the x-value of an $Si_{1-x}Ge_x$ layer greater than or equal to 0.4, thereby making the band discontinuity $\Delta E_V$ greater than or equal to 0.3 eV. However, the critical thickness of the strained growth of an $Si_{1-x}Ge_x$ layer having an x-value greater than or equal to 0.4, for the silicon substrate is less than 20 nm, and it is very difficult to form a channel layer having a sufficient thickness by strained growth.

## SUMMARY OF THE INVENTION

A transistor according to the present invention uses a high-mobility-carrier transport region as a channel or base, and the above region is formed of a germanium layer having a strain. The strain of the germanium layer is controlled by a strain control layer (that is, buffer layer) provided beneath the germanium layer. Preferably, strain control layer is formed of an $Si_{1-x}Ge_x$ layer. The strain control layer may be provided on both sides of the germanium layer. The strain of the germanium can be controlled by changing the alloy ratio $x$ of the $Si_{1-x}Ge_x$ alloyed crystal.

It is an object of the present invention to provide a high-speed switching device.

It is another object of the present invention to impose a controlled strain on a germanium layer which is a carrier transport region.

It is a further object of the present invention to provide a high-performance, heterostructure transistor, in which a layer having large lattice mismatch is formed by strained growth while suppressing the generation of misfit dislocations.

These and other objects and many of the attendant advantages of the present invention will be readily appreciated and becomes better understood by reference to the following detailed description when considered in connection with the accompanying drawing.

BRIEF DESCRIPTION OF THE DRAWINGS

Fig. 1 is a sectional view showing a conventional MODFET.

Figs. 2A and 2B are sectional views showing the first embodiment of a semiconductor device according to the present invention.

Fig. 3A is a graph showing relations in a germanium single crystal, a silicon single crystal and a GaAs single crystal between an impurity concentration and each of electron and hole mobilities.

Fig. 3B is a graph showing relations in silicon, $Si_{1-x}Ge_x$ and germanium between a temperature and a hole mobility.

Fig. 4 is a band diagram of the double heterostructure of Figs. 2A and 2B.

Fig. 5 is a sectional view showing the second embodiment of a semiconductor device according to the present invention.

Fig. 6 is a sectional view showing the third embodiment of a semiconductor device according to the present invention.

Fig. 7 is a sectional view showing the fourth embodiment of a semiconductor device according to the present invention.

Fig. 8 is a sectional view showing the fifth embodiment of a semiconductor device according to the present invention.

Figs. 9A to 10D are diagrams for explaining the sixth embodiment of a semiconductor device according to the present invention.

Fig. 11 is a sectional view showing the seventh embodiment of a semiconductor device according to the present invention.

Figs. 12A and 12B are sectional views showing the eighth embodiment of a semiconductor device according to the present invention.

Fig. 13 is a sectional view showing the ninth embodiment of a semiconductor device according to the present invention.

Fig. 14 is a sectional view showing the tenth embodiment of a semiconductor device according to the present invention.

Fig. 15 is a sectional view showing the eleventh embodiment of a semiconductor device according to the present invention.

Figs. 16 to 21 are diagrams for explaining the twelfth embodiment of a semiconductor device according to the present invention.

DESCRIPTION OF THE PREFERRED EMBODIMENTS

[EMBODIMENT-1]

Figs. 2A and 2B are sectional views showing the first embodiment of a semiconductor device according to the present invention, and show a buried germanium channel MODFET and a bipolar transistor, respectively.

In Fig. 2A, reference numeral 1 designates a silicon substrate which is a body, 2 a channel layer made of germanium, 31 and 32 SiGe alloyed crystal layers formed on both sides of the channel layer 2 and lower one is serving as strain control means (that is, strain control buffer layers), 4 a gate electrode, and 5 and 6 source and drain electrodes. Preferably, at least a portion of the strain control layers 31 and 32 formed on both side of the channel layer 2 is doped with a p-type impurity, to form a modulation-doped double heterostructure.

Preferably, the p-type impurity concentration is put in a range from $5 \times 10^{17}$ to $5 \times 10^{18}$ cm$^{-3}$. Further, the germanium channel layer 2 has a thickness of 20 nm or less, and each of the SiGe alloyed crystal layers 31 and 32 has a thickness of 20 nm or less.

In the above MODFET, the composition of the layer 31 may be different from that of the layer 32, that is, the double heterostructure may be expressed by $Si_{1-x}Ge_x/Ge/Si_{1-x}'Ge_x'$. Further, the double heterostructure including the layers 31, 2 and 33 may be replaced by a superlattice structure which is expressed by $Si_{1-x}Ge_x/Ge/Si_{1-x}Ge_x/Ge/$ --- or $Si/Ge/Si/Ge$ ---.

Fig. 2B shows a bipolar transistor, in which the strain control $Si_{1-x}Ge_x$ layer 31A acting as a collector, the p type germanium layer 21 acting as a base, and an $Si_{1-x}Ge_x$ layer 33 acting as an emitter, are successively formed on the silicon substrate 1 which is a body. Further, a collector electrode 10, a base electrode 9 and an emitter electrode 8 are formed on the layers 31, 2 and 33, respectively. It is to be noted that a compressive strain is imposed on the germanium base layer 21.

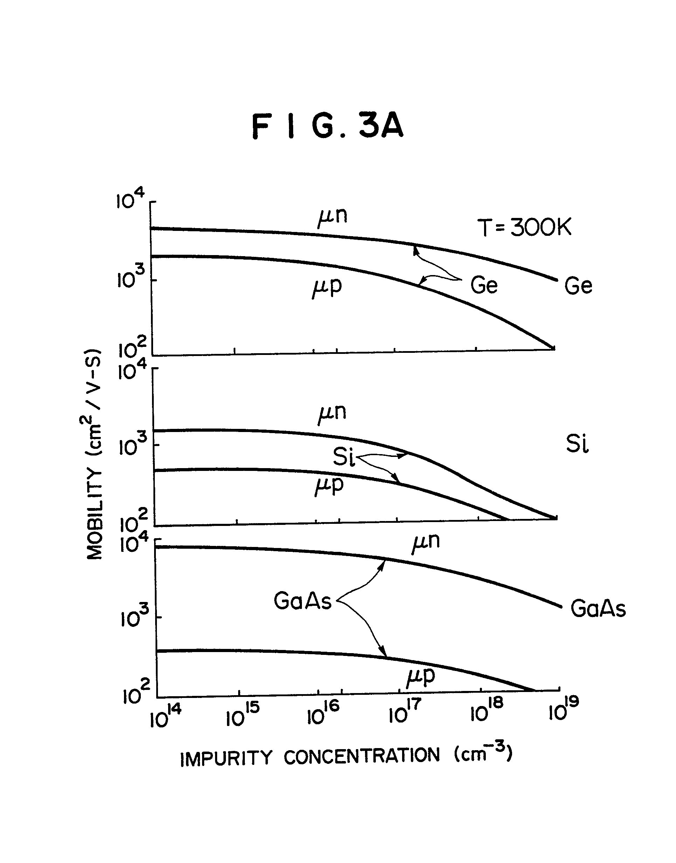

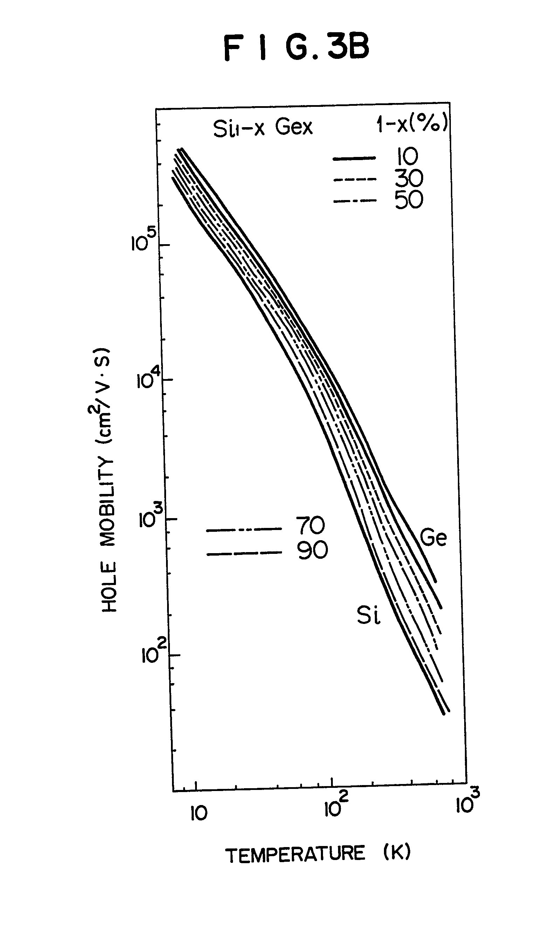

Germanium is different in electric conduction characteristics from silicon and GaAs. Fig. 3A shows relations in silicon, germanium and GaAs between an impurity concentration and each of electron and hole mobilities, and Fig. 3B shows relations in silicon, $Si_{l-x}Ge_x$ and germanium between a temperature and a hole mobility.

As can be seen from Fig. 3A, germanium has a first feature that the hole mobility $\mu_p$ in a low doping range is as high as 1,900 cm$^2$/V$\cdot$sec, and a second feature that even when the impurity concentration is increased from $10^{15}$ to $10^{19}$ cm$^{-3}$, the electron mobility $\mu_n$ is reduced only a little, that is, the mobility $\mu_n$ is reduced to about one-fourth of an original value.

The first feature of germanium is effective for an MODFET structure.

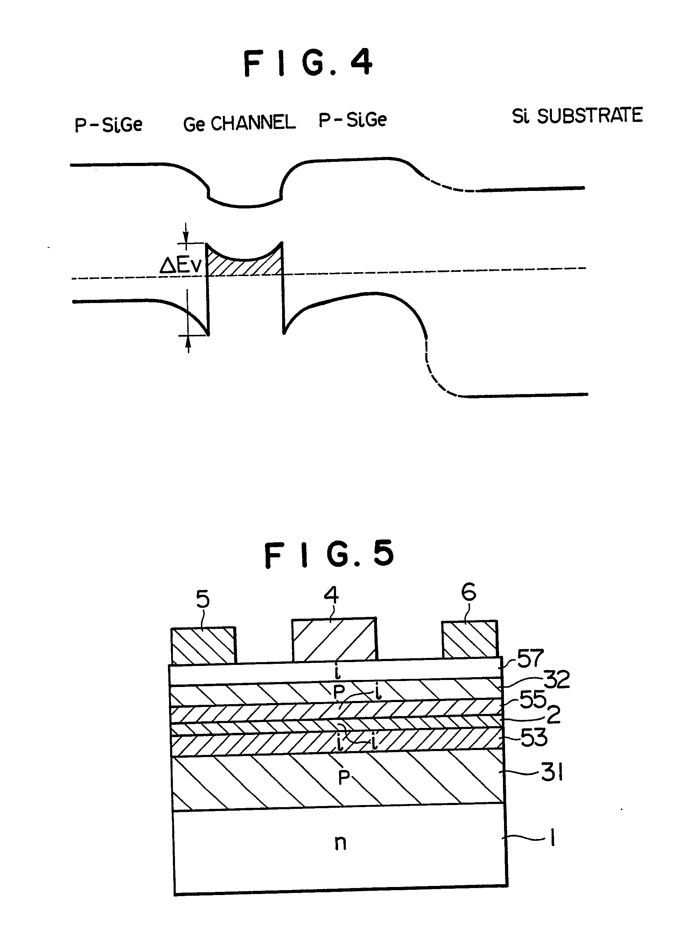

Fig. 4 is a band diagram of the double heterostructure shown in Figs. 2A and 2B. Referring to Fig. 4, positive holes are supplied from p-SiGe layers to the germanium channel layer which is sandwiched between the p-SiGe layers and forms a potential well, and travel in the germanium channel layer having a large hole mobility $\mu_p$. Owing to a difference in lattice constant between Ge and GeSi, a compressive stress is applied to the germanium layer. This compressive stress is advantageous in two points. First, the germanium layer is strained, and thus the valence-band discontinuity $\Delta E_V$ at the Ge/SiGe interface (that is, the depth of the potential well) is increased. For instance, let us consider a case where an $Si_{0.5}Ge_{0.5}$ layer is used as the SiGe layer. When the germanium layer is formed so as not to be strained, the discontinuity $\Delta E_V$ is nearly equal to 0.16 eV. When the germanium layer is strained, the discontinuity $\Delta E_V$ is nearly equal to 0.26 eV, and thus a sufficiently large number of positive holes can be confined in the potential well (that is, germanium channel layer). Secondary, the compressive stress, in some cases, can reduce the effective mass of positive hole by a factor of about ten, that is, can increase the hole mobility $\mu_p$ by a factor of about ten. Thus, a high-performance, p-MODFET can be obtained by utilizing the compressive stress.

The above effects of the compressive stress are well known. It is important that in a semiconductor device according to the present invention, the compressive stress is actually applied to a germanium layer to obtain these effects.

The second feature of germanium is effectively utilized in a doped channel FET. That is, even when a germanium channel layer is highly doped with an n-type impurity, the electron mobility $\mu_n$ is not reduced too much. That is, the electron mobility $\mu_n$ in a high impurity concentration range is about ten times as large as that in silicon. That is, the drawback of the doped-channel FET made of silicon can be overcome by using a germanium channel layer.

[EMBODIMENT-2]

Fig. 5 shows the second embodiment of a semiconductor device according to the present invention. Referring to Fig. 5, an i-germanium channel layer 2 having a thickness of 10 nm is interposed between the $p$-$Si_{0.5}Ga_{0.5}$ strain control layer 31 and the $p$-$Si_{0.5}Ga_{0.5}$ layer 32. Further, an i-$Si_{0.5}Ga_{0.5}$ spacer layer 53 is sandwiched between the $p$-$Si_{0.5}Ga_{0.5}$ layer 31 and the i-germanium channel layer 2, and another i-$Si_{0.5}Ga_{0.5}$ spacer layer 55 is sandwiched between the i-germanium channel layer 2 and the $p$-$Si_{0.5}Ga_{0.5}$ layer 32. The gate electrode 4 is made of titanium.

In more detail, the $p$-$Si_{0.5}Ga_{0.5}$ strain control layer 31 is epitaxially grown on the silicon substrate 1 to a thickness greater than 500 nm. Then, the i-$Si_{0.5}Ga_{0.5}$ layer 53 of 10 nm thick, the i-germanium channel layer 2 of 10 nm thick, the i-$Si_{0.5}Ga_{0.5}$ layer 55 of 10 nm thick, the $p$-$Si_{0.5}Ga_{0.5}$ layer 32 of 10 nm thick, and an i-$Si_{l-x}Ge_x$ layer 57 of 10 nm thick (where x lies in a range from 0.5 to 0) are successively piled on the strain control layer 31 by epitaxial growth, to form an MODFET. The epitaxial growth is carried out by using the evaporation in ultra-high vacuum (that is, molecular beam epitaxy), and the growth temperature is lower than 550$^\circ$C. Further, the p-type doping is performed by Ga atoms from a Knudsen cell, and the Ga concentration in the doped layers is made equal to $10^{18}$ cm$^{-3}$.

In the channel region of the above MODFET, the Hall mobility is about 3,000 cm$^2$/V$\cdot$sec at 300 K, and about 20,000 cm$^2$/V$\cdot$sec at 77 K. Further, the sheet carrier concentration is about 1 x $10^{12}$ cm$^{-2}$, and the effective mass of hole is 0.06 $m_o$ - (where $m_o$ is the mass of electron). As a result, the transconductance $g_m$ of the MODFET can be made equal to 200 mS/mm. Incidentally, reference numerals 5 and 6 in Fig. 5 designate source and drain electrodes.

Although a Schottky gate electrode is used in the MODFET of Fig. 5, an MOS structure may be used in place of the Schottky gate electrode. Further, a channel region including the layers 53, 2, 55 and 32 may be replaced by a superlattice structure where the i-germanium layer and the i-$Si_{0.5}Ge_{0.5}$ layer are alternately land repeatedly piled, to increase the transconductance $g_m$.

Although the silicon substrate is used in the present embodiment, a germanium substrate can be used in place of the silicon substrate. Further, various layers of the present embodiment may be formed by the chemical vapor deposition (CVD) method which is excellent in mass productivity.

[EMBODIMENT-3]

Next, explanation will be made of the third embodiment of a semiconductor device according to the present invention, in which embodiment a p-MODFET having a buried germanium channel and an n-MODFET having a germanium channel are formed on the same substrate.

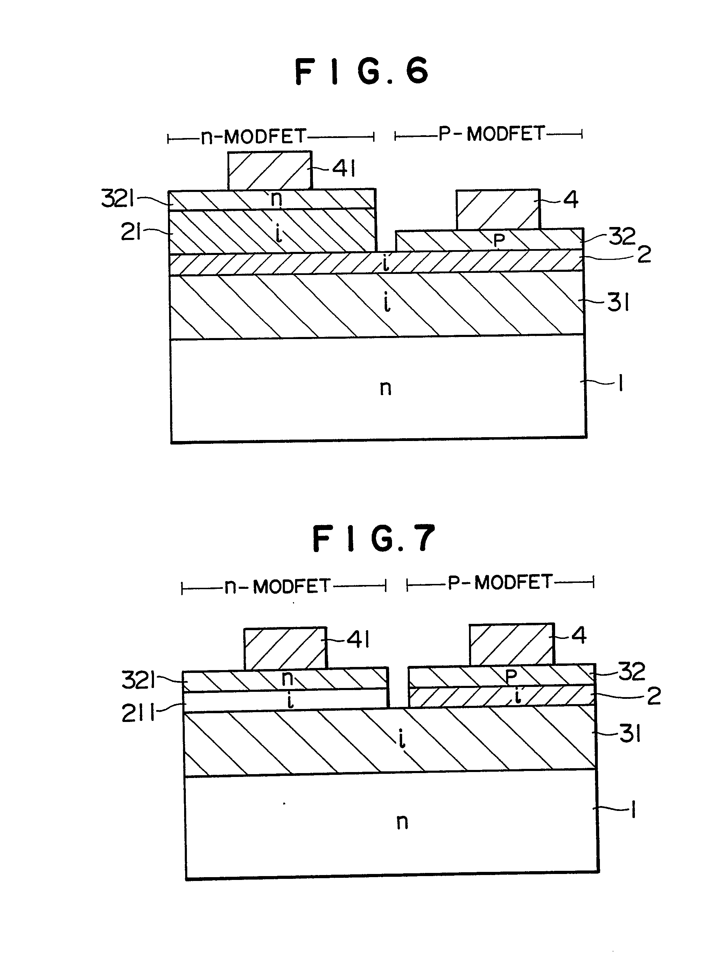

As shown in Fig. 6, the i-$Si_{0.15}Ge_{0.85}$ buffer layer 31 is grown on the n-silicon substrate 1 to a thickness of 5 00 nm, Then, the i-germanium channel layer 2 having a thickness of 20 nm is formed on the buffer layer 31. Next, that surface area of the germanium layer 2 where the p-MODFET is to be formed, is covered with an $SiO_2$ film. Then, another i-germanium channel layer 21 and an n-$Si_{0.5}Ge_{0.5}$ layer 321 are successively grown. The germanium layer 21 and $Si_{0.15}Ge_{0.85}$ layer 321 on the $SiO_2$ film are removed, together with the $SiO_2$ film. Thereafter, a portion corresponding to the n-MODFET is coated with a different $SiO_2$ film, and then the p-$Si_{0.5}Ge_{0.5}$ layer 32 is grown. The $Si_{0.5}Ge_{0.5}$ layer on the $SiO_2$ film is removed, together with the $SiO_2$ film. Thereafter, gate electrodes 4 and 41 are formed.

In the present embodiment, the germanium channel of the p-MODFET is strained by compressive stress, and thus the valence-band discontinuity $\Delta E_V$ is large. Accordingly, a sufficiently large number of positive holes can be confined in the channel. While, the germanium channel of the n-MODFET is not strained, and the conduction-band discontinuity $\Delta E_C$ is large. Accordingly, a sufficiently large number of electrons can be confined in the germanium channel.

According to the present embodiment, germanium-channel, p-MODFET's and germanium-channel, n-MODFET's can be formed on the same substrate. Thus, a high-speed complementary logic circuit can be obtained.

[EMBODIMENT-4]

Fig. 7 shows the fourth embodiment of a semiconductor device according to the present invention, in which embodiment an n-MODFET and a p-MODFET are formed on the same substrate. The present embodiment, however, is different from the third embodiment in that the channel layer of the n-MODFET is formed of an i-silicon layer 211 which has been strained. Thus, in the n-MODFET, the conduction-band discontinuity $\Delta E_C$ can be increased to about 0.15 eV. In the present embodiment, the i-$Si_{0.5}Se_{0.5}$ strain control layer (that is, buffer layer) 31 is formed on the n-silicon substrate 1, and the i-silicon channel layer 211 and the i-germanium channel layer 2 are formed on the buffer layer 31. Further, an n-$Si_{0.5}Ge_{0.5}$ layer 321 is formed on the i-silicon channel layer 211, and the p-$Si_{0.5}Ge_{0.5}$ layer 31 is formed on the i-germanium channel layer 2. The gate electrode 41 of the n-MODFET and the gate electrode 4 of the p-MODFET are formed as shown in Fig. 7. Further, the source and drain electrodes (not shown) of each of the n-MODFET and p-MODFET are formed. Then, an insulating film, a passivation film, and others are formed to complete a complementary MODFET.

[EMBODIMENT-5]

Next, explanation will be made of the fifth embodiment of a semiconductor device according to the present invention which embodiment is a doped germanium channel MODFET.

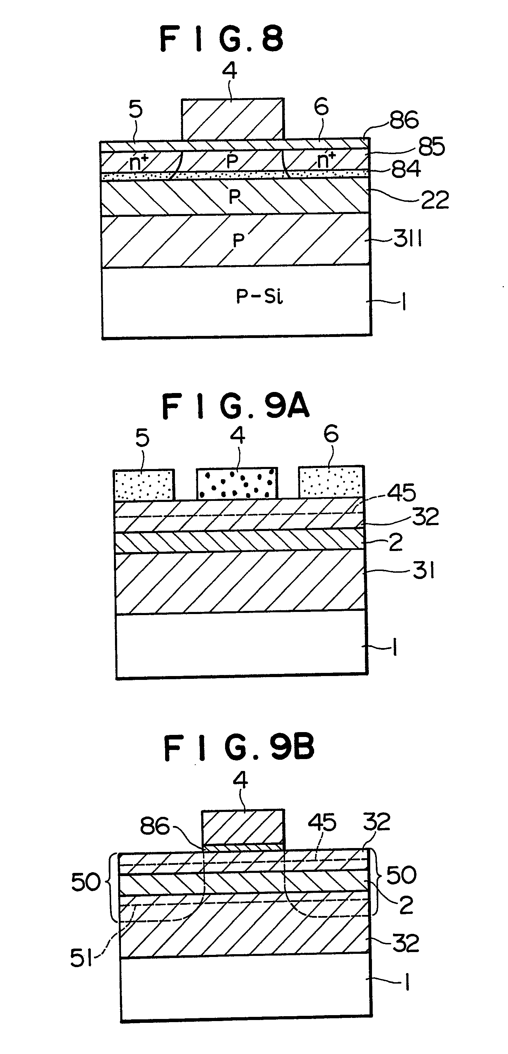

As shown in Fig. 8, a p-$Si_{0.5}Ge_{0.5}$ buffer layer 311 is grown on a p-silicon substrate 1 to a thickness of 500 nm, and then a p-germanium layer 22 is grown on the buffer layer 311 to a thickness of 300 nm After the germanium layer 22 has been grown, antimony is evaporated in a molecular beam epitaxy apparatus, to be deposited on the germanium layer 22. Then, Sb atoms are desorbed at 600 °C, to leave only one atomic layer 84 of antimony. Next, the temperature of the substrate 1 is reduced to 50 °C, and an amorphous germanium layer is grown to a thickness of 50 nm. Then, the substrate temperature is raised to 600 °C, to crystallize the amorphous germanium layer by solid epitaxial growth.

Thereafter, an $SiO_2$ gate film 86 is formed by the plasma CVD method, and an aluminum gate electrode 4 is formed on the $SiO_2$ film 86. Then, ion implanation is carried out while using the gate electrode 4 as a mask. That is, arsenic ions are implanted in a p-germanium layer 85 to form source and drain regions 5 and 6.

In a high impurity concentration range, the electron mobility $\mu_n$ in germanium is about ten times as high as that in silicon. Accordingly, the present embodiment (that is, doped germanium channel MOSFET) is more than five times greater in transconductance than a conventional doped-channel FET.

According to the present embodiment, a high-speed operation can be performed, since the carrier transport channel is made of germanium. Further, not only the electron mobility $\mu_n$ but also the hole mobility $\mu_p$ is very large in germanium. Thus, a favorable complementary logic circuit can be formed. Furthermore, in a doped channel layer, the sheet carrier concentration is large, and moreover the reduction in electron mobility $\mu_n$ is suppressed. Hence, a high transconductance can be obtained.

[EMBODIMENT-6]

Fig. 9A shows the sixth embodiment of a semiconductor device according to the present invention which embodiment is a p-channel, modulation-doped transistor.

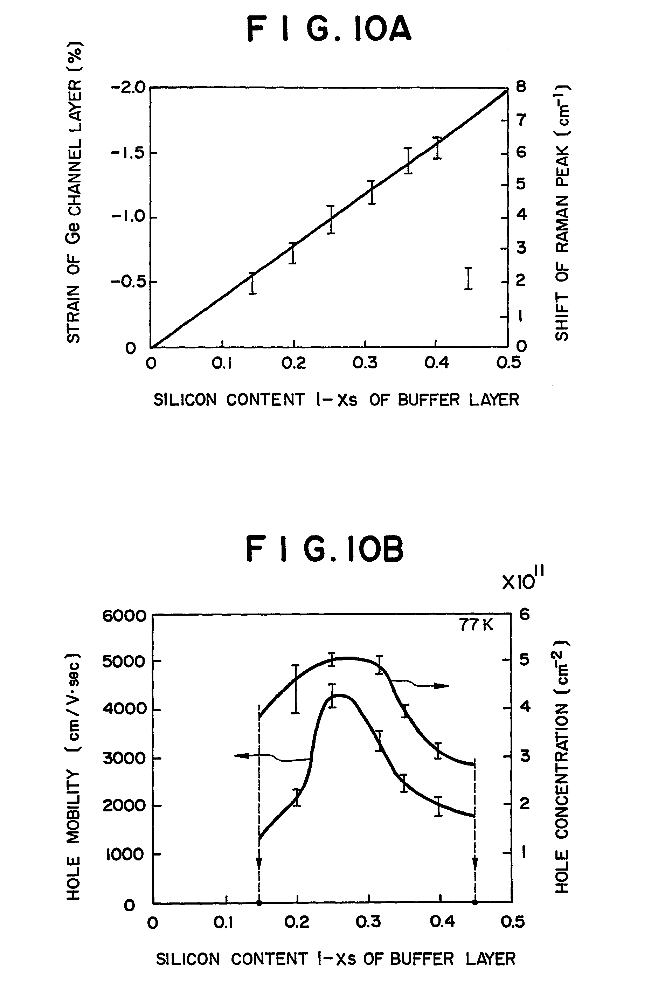

Referring to Fig. 9A, an $Si_{l-x_s}Ge_{x_s}$ buffer layer 31 where $0.15 \leq 1 - x_s \leq 0.45$) having a thickness of 500 nm is heteroepitaxially grown on an n-germanium substrate 1 kept at 520°C, by molecular beam epitaxy. Then, the germanium channel layer 2 of 20 nm thick and the $p$-$Si_{0.5}Ge_{0.5}$ layer 32 of 30 nm thick are grown at a substrate temperature of 400°C. The thickness of the buffer layer 31 is greater than the critical thickness of strained growth. Hence, many misfit dislocations are generated at the interface between the substrate 1 and the buffer layer 31, and that portion of the buffer layer 31 which is kept in contact with the substrate 1, becomes equal in lattice constant to the bulk of the buffer layer 31. That is, the buffer layer 31 is formed by incommensulate growth (that is, relaxed growth). While, the thickness of each of the germanium layer 2 and the $Si_{0.5}Ge_{0.5}$ layer 32 is far smaller than the critical thickness of strained growth. Hence, these layers 2 and 32 are grown so as to be equal in in-plane lattice constant to the buffer layer 31. That is, the layers 2 and 32 are formed by commensulate growth (namely, strained growth). The above facts have been confirmed by the TEM observation of a cross section and the Raman scattering spectroscopy. Fig. 10A shows a relation between the silicon content $l$-$x_s$ of the buffer layer and the strain of the germanium channel layer determined by the Raman scattering spectroscopy. The strain of the germanium channel layer is compressive strain, and is proportional to the silicon content $l$-$x_s$ of the buffer layer as in theory. It is to be noted that in a case where the silicon content $l$-$x_s$ of the buffer layer is 0.45, the thickness of the germanium layer equal to 20 nm exceeds the critical thickness of commensulate growth, and thus the germanium layer is formed by incommensulate growth (that is, relaxed growth).

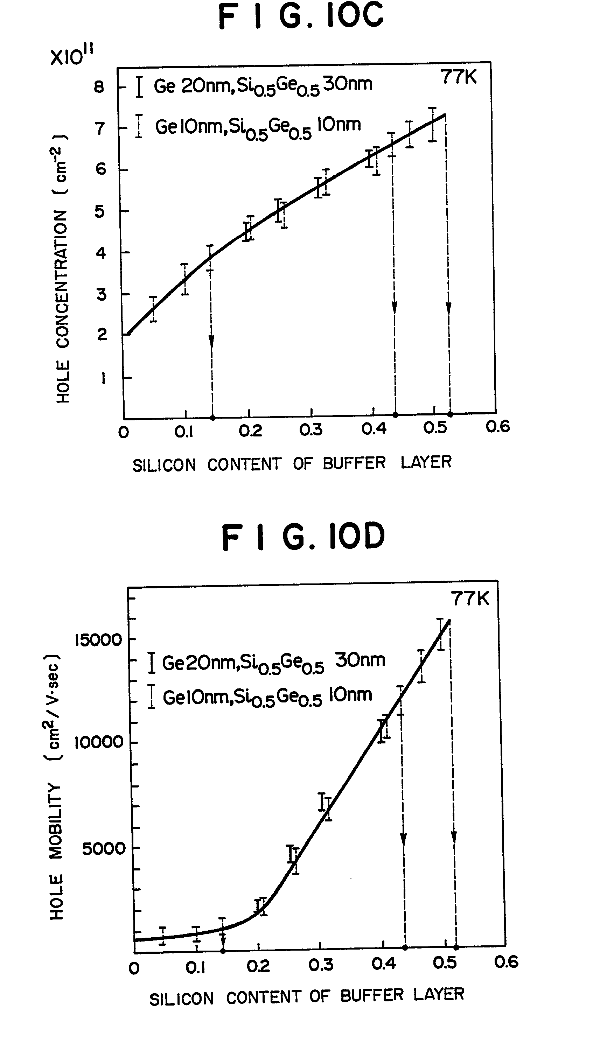

The $Si_{0.5}Ge_{0.5}$ layer 32 is doped with a p-type impurity by the so-called $\delta$-doping. That is, an $Si_{0.5}Ge_{0.5}$ film having a thickness of 15 nm is first grown at a substrate temperature of 400°C. Then, the substrate temperature is reduced to 50°C, and Ga atoms are absorbed by the surface of the $Si_{0.5}Ge_{0.5}$ film. Thereafter, an amorphous $Si_{0.5}Ge_{0.5}$ film having a thickness of 15 nm is deposited. Then, the substrate temperature is raised to 450°C, to crystallize the amorphous film by solid phase epitaxy. Thus, Ga atoms 45 are buried in the $Si_{0.5}Ge_{0.5}$ layer 32 in the form of a spike. An AuGa electrode is formed on the above structure, to investigate the electric conduction property of the structure. Fig. 10B shows a relation between the silicon content $l$-$x_s$ of the buffer layer and the hole mobility determined from Hall-effect measurements at 77 K and a relation between the silicon content $l$-$x_s$ and the hole concentration determined from Hall-effect measurements at 77 K. In a range where the silicon content $l$-$x_s$ is less than 0.25, the hole mobility and hole concentration increase with the increasing silicon content, as expected. In a range where the silicon content is greater than 0.25, however, the hole mobility and hole concentration decrease with the increasing silicon content. From the TEM observation of a cross section, it has been known that threading dislocations are abruptly increased in the range of $l$-$x_s$ > 0.25. That is, it has been suggested that the hole mobility and hole concentration are reduced by the dislocations. In order to reduce the threading dislocations, the thickness of the $Si_{l-x_s}Ge_{x_s}$ buffer layer is increased to 2 $\mu$m, and a layer having a superlattice structure $Si_{l-x_s}Ge_{x_s}/Ge/Si_{l-x_s}Ge_{x_s}/Ge/$ --- is provided between the germanium substrate 1 and the buffer layer 31. In this case, the hole mobility and hole concentration are increased in the range of $l$-$x_s$ > 0.25, as shown in Figs. 10C and 10D. Even in the above case, when the silicon content $l$-$x_s$ is made greater than 0.4 or less than 0.15, dislocations are generated in the germanium channel layer 2 or the $Si_{0.5}Ge_{0.5}$ layer 32, and the layer 2 or 32 is formed by incommensulate growth. Thus, a two-dimensional hole gas is not observed, as indicated by black points in Figs. 10C and 10D. In other words, in a case where the germanium layer has a thickness of 20 nm and the $Si_{0.5}Ge_{0.5}$ layer has a thickness of 30 nm, it is preferable to put the silicon content of the buffer layer in a range from 0.2 to 0.4 (that is, $0.2 \leq l$-$x_s \leq 0.4$). Further, in a case where each of the germanium layer and the $Si_{0.5}Ge_{0.5}$ layer has a thickness of 10 nm, the silicon content of the buffer layer can be put in a range from 0 to 0.5 (that is, $0 < l$-$x_s \leq 0.5$). Although the germanium substrate is used in the present embodiment, a silicon substrate may be used in place of the germanium substrate.

A maximum hole mobility achieved by the present embodiment is 50,000 cm²/V·sec at 77 K. This value is about hundred times as high as a conventional value.

The gate electrode 4 made of titanium was provided on the above-mentioned structure, to form a field effect transistor having a gate length of about 2 $\mu$m. The field effect mobility in this transistor was calculated from the dependence of the transductance on the gate voltage $V_G$, and found to be greater than 10,000 cm²/V·sec.

Fig. 9B shows a modified version of the structure of Fig. 9A. Referring to Fig. 9B, a WSi gate 4 is formed on a gate insulating film 86, and $P^+$-

regions 50 are formed in a self-aligned structure, to form an MOSFET which has a gate length less than 1 $\mu$m. Further, in order to prevent the punch through due to miniaturization, an Sb doping spike 51 is formed as shown in Fig. 9B. In an ordinary n-channel MOSFET using silicon, the velocity overshoot, that is, a phenomenon that the carrier velocity exceeds the saturation velocity, can be observed only when the channel length is less than 0.1 $\mu$m. While, in the MOSFET of Fig. 9B, the Hall mobility is high, and thus the velocity overshooting is generated even when the channel length is about 0.3 $\mu$m. That is, the performance of the MOSFET is improved by the velocity overshooting.

[EMBODIMENT-7]

Next, explanation will be made of the seventh embodiment of a semiconductor device according to the present invention which embodiment is a p-channel, doped-channel FET.

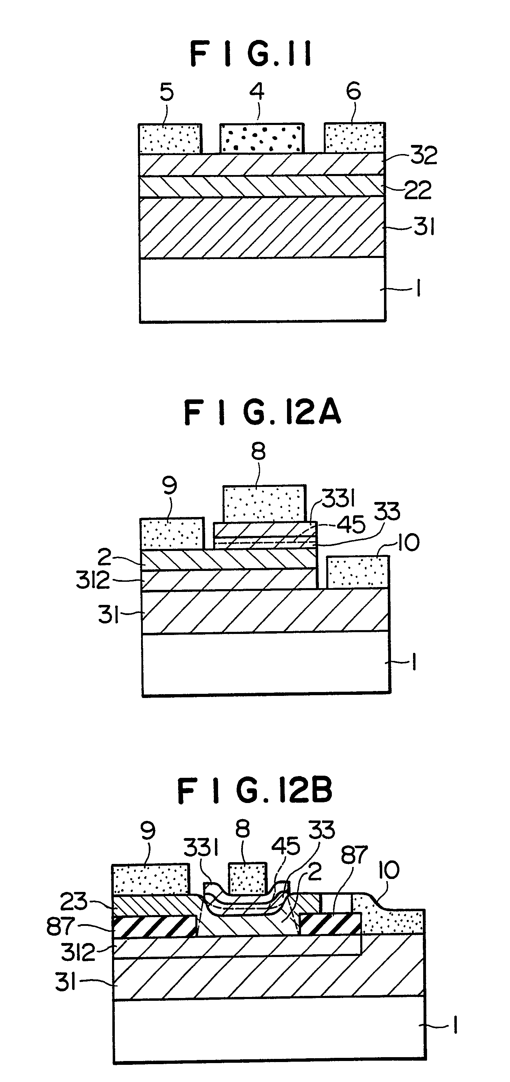

Referring to Fig. 11, a p-type germanium channel layer 22 is formed in such a manner that a germanium layer is grown on the buffer layer 31 by the chemical vapor deposition method using a GeH$_4$ gas, and the germanium layer is doped with boron atoms from a B$_2$H$_6$ gas at a boron concentration of $1 \times 10^{-8}$ cm$^{-3}$. The germanium channel layer 22 is strained, and hence the hole mobility in the channel layer 22 is about twice as large as that in an ordinary germanium layer. Further, the hole concentration in the germanium channel layer 22 is high. Accordingly, the present embodiment is substantially equal in transconductance at room temperature to the modulation-doped transistor of Fig. 9A. In Fig. 11, the same reference numerals as in Fig. 9A designate like parts.

[EMBODIMENT-8]

Next, explanation will be made of the eighth embodiment of a semiconductor device according to the present invention which embodiment is a bipolar transistor utilizing a two-dimensional hole gas.

As shown in Fig. 12A, an n$^+$-Si$_{0.25}$Ge$_{0.75}$ collector layer 31 of 800 nm thick and an n$^-$-Si$_{0.25}$Ge$_{0.75}$ collector layer 312 of 200 nm thick are grown by molecular beam epitaxy, in a state that a p-germanium substrate 1 is kept at 520°C. Then, an undoped germanium base layer 2 of 20 nm thick, an undoped Si$_{04}$Ge$_{0.6}$ layer 33 having a Ga doping spike 45 and a thickness of 20 nm, and an n$^-$-Si$_{0.4}$Ge$_{0.6}$ emitter layer 331 of 80 nm thick are successively formed. In the above structure, a two-dimensional hole gas produced at the interface between the undoped Si$_{0.4}$Ge$_{0.6}$ layer and the germanium layer serves as a low-resistance, thin base. After it has been confirmed that the structure of Fig. 12A can operate as a bipolar transistor, a transistor shown in Fig. 12B was fabricated. Referring to Fig. 12B, an SiO$_2$ film 87 was formed by the chemical vapor deposition method, and an aperture was provided in the SiO$_2$ film 87 at a position corresponding to the undoped Si$_{0.4}$Ge$_{0.6}$ layer 33. Then, the base and emitter layers were formed as shown in Fig. 12B. In this structure, an extrinsic base portion was formed of a p$^+$-polycrystalline germanium film 23, and thus the parasitic resistance and capacitance due to the outer base portion were greatly reduced. Further, the transition frequency f$_T$ of the above transistor was 150 GHz. In Fig. 12a and 12B, the same reference numerals designate like parts.

[EMBODIMENT-9]

Next, explanation will be made of the ninth embodiment of a semiconductor device according to the present invention which embodiment is a heterostructure, bipolar transistor having an ordinary p-base layer.

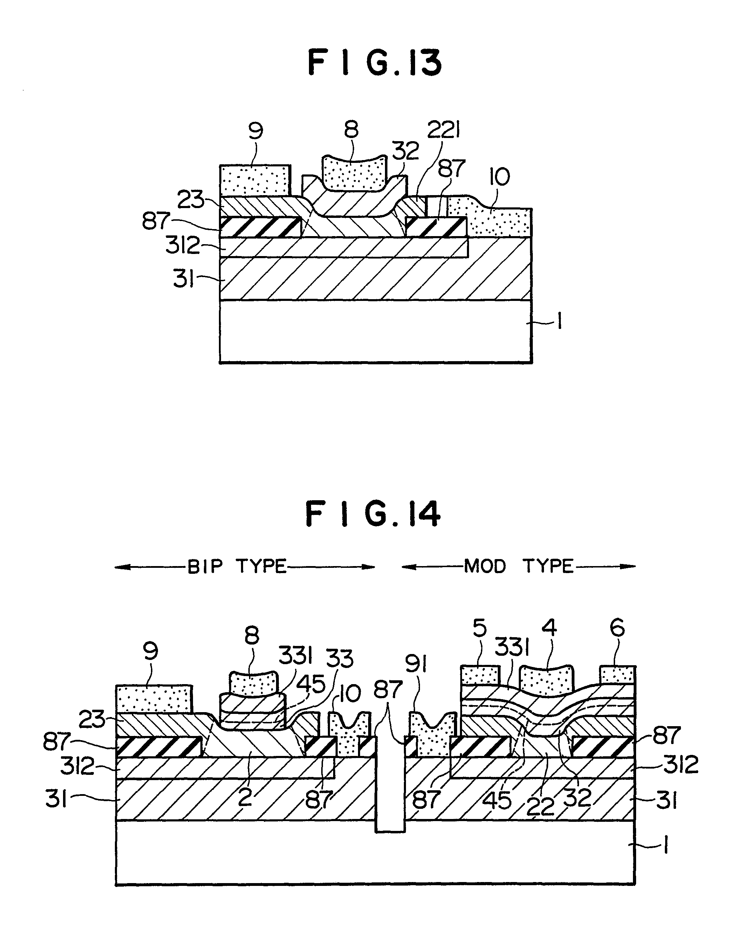

As shown in Fig. 13, a p-germanium base layer 221 is formed in the same manner as in the EMBODIMENT-7. The boron concentration of the base layer 221 is made equal to $1 \times 10^{19}$ cm$^{-3}$. The hole mobility in germanium is large even in a high impurity concentration range due to strain effect. Accordingly, the transition frequency f$_T$ of the present embodiment is as high as 150 GHz. In Fig. 13, the same reference numerals as in Figs. 12A and 12B designate equivalent or identical parts.

[EMBODIMENT-10]

Next, explanation will be made of the tenth embodiment of a semiconductor device according to the present invention, in which embodiment a p-channel field effect transistor and a bipolar transistor each utilizing a two-dimensional hole gas are formed on the same substrate so as to form an integrated circuit.

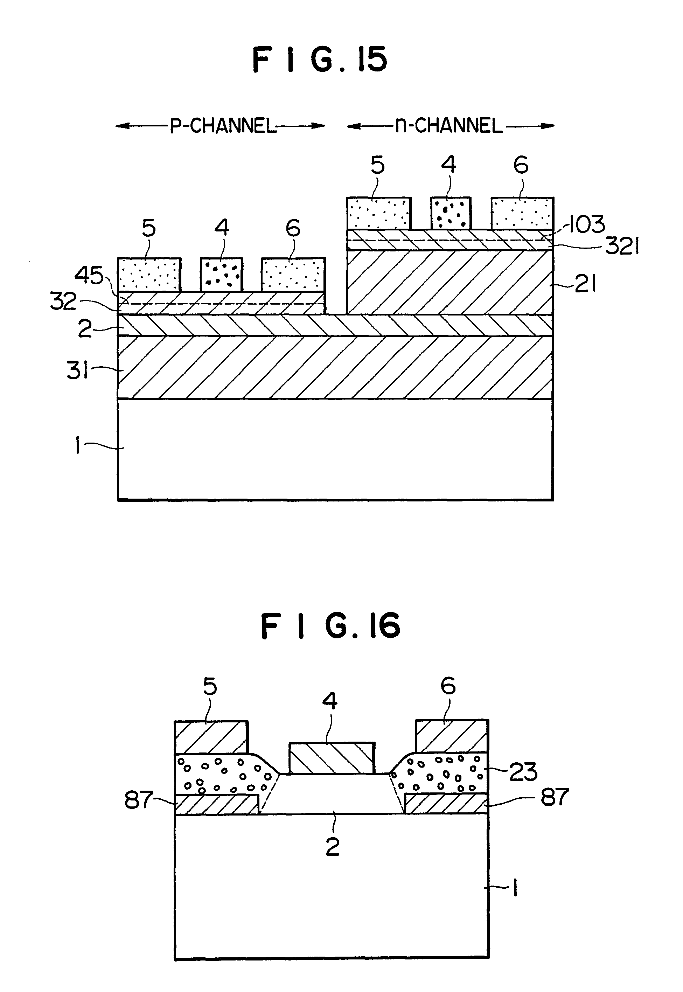

As shown in Fig. 14, the field effect transistor and the bipolar transistor have the same structure, in the direction of thickness. Accordingly, the present embodiment can be formed in the same manner as in the fabrication method of the bipolar transistor described in the EMBODIMENT-8. According to the present embodiment, a monolithic integrated circuit is formed of bipolar transistors which are high in current driving capacity, and field effect transistors which are suited to form an integrated circuit. Thus, an ultra-high-speed logic circuit can be obtained. In Fig. 14, reference numeral 91 designates an electrode for applying a bias voltage to the substrate, 31 an $n^+$-$Si_{0.25}Ge_{0.75}$ buffer layer, 312 an $n^-$-$Si_{0.25}Ge_{0.75}$ buffer layer, and 331 an $n^+$-$Si_{0.4}Ge_{0.6}$ layer.

[EMBODIMENT-11]

Next, explanation will be made of the eleventh embodiment of a semiconductor device according to the present invention, in which embodiment p-channel and n-channel modulation-doped transistors are formed on the same substrate so as to form an integrated circuit.

As shown in Fig. 15, the p-channel transistor is equal in structure to the transistor of Fig. 9A, and the n-channel transistor uses a germanium layer 21 which is formed by incommensulate growth (that is, relaxed growth), as the channel layer. This is because when the germanium layer 21 has no strain, a large conduction-band discontinuity $\Delta E_C$ is obtained at an $Si_{0.15}Ge_{0.85}$/Ge interface. According to the present embodiment, a complementary logic circuit can be obtained which operates at high speed and is low in power dissipation. In Fig. 15, reference numeral 321 designates an $Si_{0.15}Ge_{0.85}$ layer, and 103 an Sb doping spike.

According to the above embodiment, a two-dimensional hole gas is generated in a germanium layer having a compressive strain, and the high-speed operation of a field effect transistor or bipolar transistor is achieved by utilizing the two-dimensional hole gas.

[EMBODIMENT-12]

In the above embodiments, a compressive strain is imposed on a germanium layer which is a carrier transport layer, by a strain control layer. However, when the difference in lattice constant between the germanium layer and the strain control layer is greater than a predetermined value, misfit dislocations are generated, and thus the carrier mobility is abruptly decreased, as has been explained with reference to Figs. 10B, 10C and 10D. A structure for suppressing the generation of misfit dislocations is used in the twelfth embodiment of a semiconductor device according to the present invention which embodiment is a field effect transistor.

In the present embodiment, an insulating layer 87 is formed just under a source 5 and a drain 6. In more detail, a main surface of a monocrystalline substrate 1 is coated by the insulating layer 87, and an aperture is provided in the insulating layer 87 at a channel portion 2. Then, a semiconductor layer is formed all over the surface through heteroepitaxial growth techniques.

As will be explained later, the above structure is especially effective for a case where the substrate is made of a material having a band gap Eg less than 1 eV such as germanium.

Next, explanation will be made of the operation of the above structure in a case where a heterostructure SiGe/Si is used, by way of example.

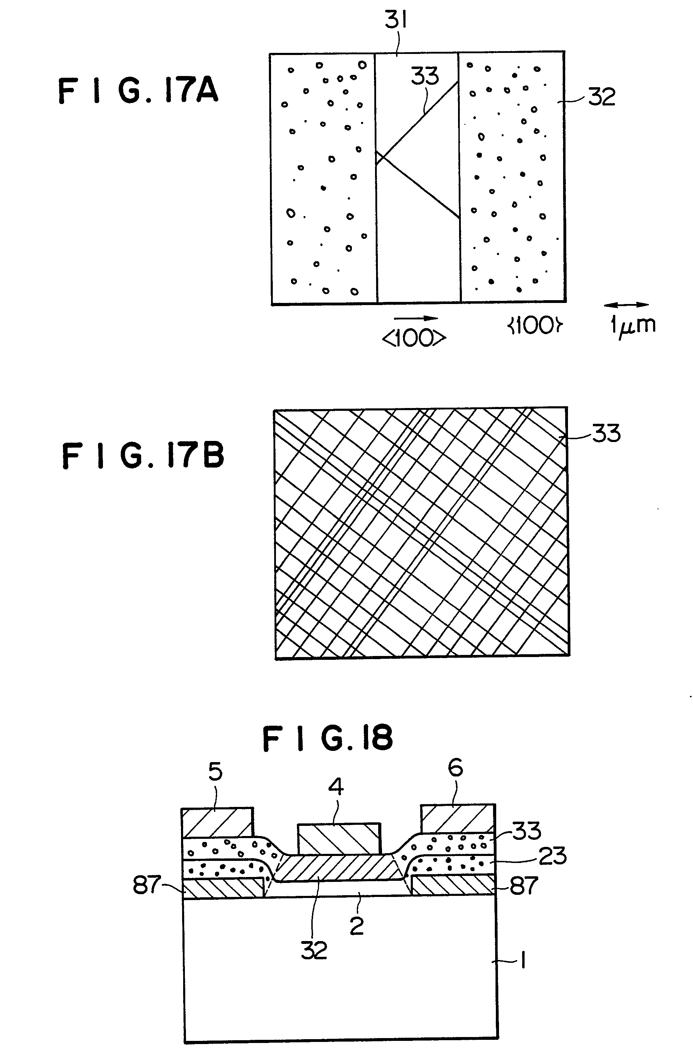

Fig. 17A is a TEM image of a sample which is formed in such a manner that a stripe-shaped aperture is provided in an $SiO_2$ film, and an $Si_{0.5}Ge_{0.5}$ film of 20nm thick is grown on the whole surface. Fig. 17B shows a case where the $Si_{0.5}Ge_{0.5}$ film is epitaxially grown on a silicon substrate without interposing the $SiO_2$ film between the $Si_{0.5}Ge_{0.5}$ film and the silicon substrate. As is apparent from Figs. 17A and Figs. 17B, when only the stripe-shaped portion of the $Si_{0.5}Ge_{0.5}$ film is crystallized without being affected by the $SiO_2$ film, misfit dislocations are decreased in a great degree. This is because the strain due to lattice mismatch is relieved at the boundary between the stripe-shaped $Si_{0.5}Ge_{0.5}$ single crystal and the $Si_{0.5}Ge_{0.5}$ poly-crystal formed on the $SiO_2$ film, which poly-crystal is indicated by reference numeral 23 in Fig. 16.

Further, the structure that the insulating film is formed beneath the source and drain portions is nothing but an SOI (semiconductor on insulator) structure. Accordingly, this structure can reduce the parasitic capacitance of the pn junctions of the source and the drain, and thus makes possible the high-speed operation of a device concerned.

In a case where the substrate is made of a material having a small band gap such as germanium, a considerable amount of reverse leakage current flows through the pn junction between the substrate and a channel layer at room temperature, and thus carriers travel in the substrate. Accordingly, it is difficult to operate the device at room temperature. According to the present embodiment, the area of the pn junction is limited, as shown in Fig. 16. Thus, the leakage current is reduced, and the device can operate at room temperature.

Further, explanation will be made of a p-MOD-FET including an $Si_{0.6}Ge_{0.4}$ channel layer. Referring to Fig. 18, an $SiO_2$ film 87 is formed on a silicon substrate 1 by the LOCOS (localized oxidation of silicon) method. Then, an $Si_{0.6}Ge_{0.4}$ film 2 of 20nm thick and a p-silicon film 32 of 30 nm thick are successively grown at a substrate temperature of 400° C by molecular beam epitaxy. At this time, polycrystalline regions 23 and 33 are formed on

the SiO₂ film. Next, a titanium gate electrode 4, an AuGa source electrode 5 and an AuGa drain electrode 6 are formed by vacuum evaporation. The alloying for putting the AuGa electrodes in ohmic contact with the region 33 is done at 330°C. Hall-effect measurements were made for this p-MODFET, and it was found that the sheet carrier concentration $N_S$ at 77 K was equal to $1 \times 10^{12}$ cm$^{-2}$ and the Hall mobility $\mu$ at 77 K was equal to 5,000 cm²/V·sec. These values were far superior to the conventional ones. This is because the alloy ratio x of the $Si_{1-x}Ge_x$ channel layer is made as high as $0.\overline{4}$ and hence the valence-band discontinuity $\Delta E_v$ is as large as 0.3 eV, and because a compressive strain of about 1.6% reduces the effective mass of positive hole. Thus, the transconductance of the MODFET was 50 mS/mm.

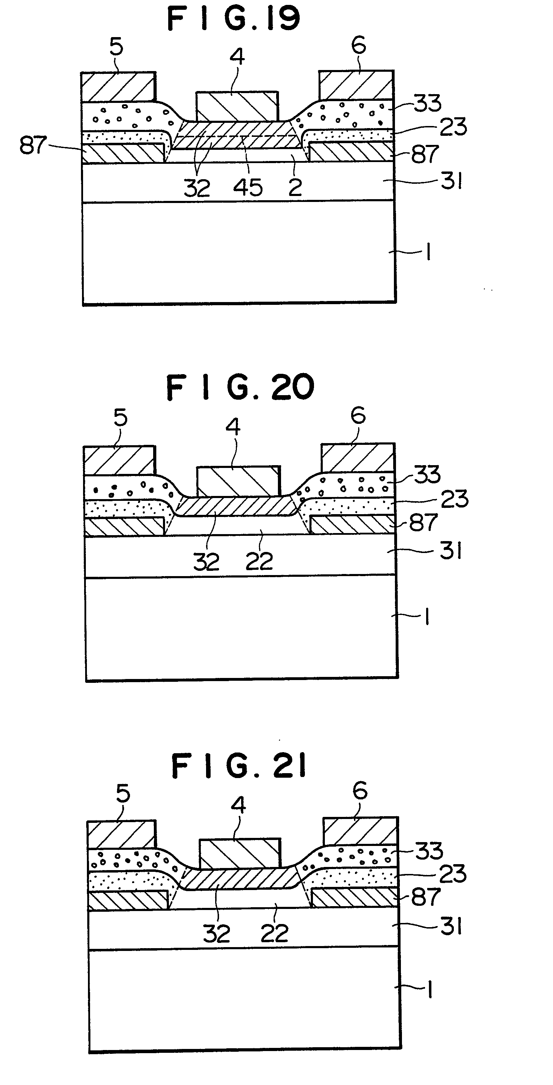

Next, explanation will be made of a p-MODFET including a germanium channel layer. Referring to Fig. 19, an $Si_{0.5}Ge_{0.5}$ buffer layer 31 of 200 nm thick is epitaxially grown on a germanium or silicon substrate 1 at a substrate temperature of 520°C. Next, an SiO₂ film 87 is formed by the plasma CVD method, and is then patterned. Thereafter, a germanium channel layer 2 of 20 nm thick and an $Si_{0.5}Ge_{0.5}$ film 32 of 15 nm thick are grown at a substrate temperature of 400°C. Then, the substrate temperature is reduced to room temperature. Next, Ga atoms are absorbed by the surface of the $Si_{0.5}Ge_{0.5}$ film 32, and an amorphous $Si_{0.5}Ge_{0.5}$ film of 15 nm thick is deposited. Then, the substrate is kept at 450°C for one hour, to crystallize the amorphous $Si_{0.5}Ge_{0.5}$ film by solid epitaxial growth. Thus, a Ga doping spike 45 is buried in an $Si_{0.5}Ge_{0.5}$ layer.

In this MODFET, holes travel in the undoped germanium layer which has been subjected to a compressive strain. In the undoped germanium layer, the hole mobility is large, and moreover alloy scattering does not occur. Further, the effective mass of hole is reduced by the compressive strain. Thus, the hole mobility is 10,000 cm²/V·sec at room temperature, and is 50,000 cm²/V·sec at 77 K. The transconductance $g_m$ of the MODFET is 100 mS/mm at room temperature, and is 200 mS/mm at 77 K.

Fig. 20 shows a p-channel, doped-channel FET including a boron-doped germanium channel layer 22.

Like the MODFET of Fig. 19, the FET of Fig. 20 includes a strained germanium layer. However, the FET of Fig. 20 is different from the MODFET of Fig. 19 in that the germanium layer 22 of 20 nm thick is doped with boron at an impurity concentration of about $10^{18}$ cm$^{-3}$ The doped-channel FET of Fig. 20 is fabricated in substantially the same manner as the MODFET of Fig. 19, and the boron doping is carried out by the evaporation method using a germanium source which contains boron. This doped-channel FET is advantageous in that the sheet carrier concentration can be made as high as $2 \times 10^{12}$ cm$^{-2}$.

Next, explanation will be made of an N-channel, doped-channel FET including an antimony-doped germanium layer 22 which FET is shown in Fig. 21.

The doped-channel FET of Fig. 21 is different from the doped-channel FET of Fig. 20 in that the dopant is antimony, and a gate electrode 4 is made of platinum or gold. Even when a germanium layer is doped with an n-type impurity at an impurity concentration of $10^{18}$ cm$^{-3}$, the electron mobility in the germanium layer is as high as about 1,000 cm²/V·sec, and thus an FET including such a germanium channel layer has a high transconductance at room temperature. The transconductance of the doped channel FET of Fig. 21 is 100 mS/mm at room temperature.

The present embodiment is not limited to a silicon-germanium system, but is applicable to other hetero systems such as a GaInAs-GaAs system and a GaInAs-AlInAs system.

According to the present embodiment, a semiconductor film having large lattice mismatch can be epitaxially grown without generating misfit dislocations, and hence a strain effect is effectively utilized. Moreover, the parasitic capacitance and the leakage current are reduced. Thus, a heterostructure FET can be realized which performs a high-speed operation at high and low temperatures.

As has been explained in the foregoing, according to the present invention, an ultra-high-speed transistor can be obtained. Further, high-speed MODFET'S and bipolar transistors can be readily formed on the same substrate to make an integrated circuit. That is, an integrated circuit can be obtained which has a high operation speed. Furthermore, in a case where a complementary circuit is formed of p-type MODFET's and n-type MODFET's, the carrier mobility is high in each of the p-type MODFET and the n-type MODFET, and thus the complementary circuit can perform a high-speed operation.

In addition, when a large compressive strain is imposed on a channel layer as shown in Fig. 16, the carrier mobility in the channel layer can be increased to a limit value.

It is further understood by those skilled in the art that the foregoing description shows only preferred embodiments of the disclosed device and that various changes and modifications may be made in the invention without departing from the spirit and scope thereof.

## Claims

1. A semiconductor device comprising:
a substrate (1);
a strain control layer (31, 31A) formed on the substrate (1); and
a germanium layer (2, 21) formed on the strain control layer (31, 31A), the germanium layer (2, 21) being a carrier transport region, a compressive strain being imposed on the germanium layer (2, 21) by the strain control layer (31, 31A).

2. A semiconductor device according to Claim 1, wherein the strain control layer (31, 31A) is formed of a silicon-germanium alloyed crystal, and the strain of the germanium layer (2, 21) can be changed by varying the alloy ratio of the silicon-germanium alloyed crystal.

3. A semiconductor device according to Claim 2, wherein at least a portion of the silicon-germanium alloyed crystal is doped with a p-type impurity.

4. A semiconductor device according to Claim 2, wherein each of the germanium layer and the silicon-germanium alloyed crystal layer has a thickness of 20nm or less.

5. A semiconductor device according to Claim 2, wherein the semiconductor device is a heterostructure field effect transistor having a gate (4), a source (5) and a drain (6), and an insulating film is provided beneath the source (5) and the drain (6).

6. A semiconductor device according to Claim 2, wherein the semiconductor device is a heterostructure bipolar transistor having an extrinsic base region (23) on an insulating film (89).

7. A semiconductor device according to Claim 2, wherein the substrate (1) is made of a material having a band gap Eg less than 1 eV.

8. A seniconductor device according to Claim 2, wherein the germanium layer and the silicon-germanium alloyed crystal layer are alternately and repeatedly piled.

9. A semiconductor device comprising:
a body (1);
means (31, 31A) formed on the body (1) for controlling the strain of a germanium layer (2, 21);
the germanium layer (2, 21) formed on the strain control means (31, 31A), carriers being forced to travel in the germanium layer (2, 21); and
a first layer formed on the germanium layer.

10. A semiconductor device according to Claim 9, wherein the strain control means (31, 31A) is an $Si_{1-x_s} Ge_{x_s}$ layer.

11. A semiconductor device according to Claim 10, wherein the silicon content $l-x_s$ of the $Si_{1-x_s} Ge_{x_s}$ layer satisfies a relation $0.15 \leq 1 - x_s \leq 0.45$.

12. A semiconductor device according to Claim 11, wherein the thickness of the germanium layer lies (2, 21) in a range from 10 to 30 nm.

13. A semiconductor device according to Claim 9, wherein the strain control means (31, 31A) is an $Si_{1-x_s} Ge_{x_s}$ layer, and the silicon content $l-x_s$ of the $Si_{1-x_s} Ge_{x_s}$ layer is about 0.25.

14. A semiconductor device according to Claim 9, wherein the germanium layer (2) is the channel layer of a field effect transistor.

15. A semiconductor device according to Claim 9, wherein the germanium layer (21) is the base layer of a bipolar transistor.

16. A field effect transistor comprising:
a carrier-transport channel layer (2) made of germanium; and
a buffer layer (31) provided beneath the germanium channel layer (2) for imposing a compressive strain on the germanium channel layer (2), the buffer layer (31) being made of one of an $Si_{1-x_s} Ge_{x_s}$ alloyed crystal (where $0 < x_s < 1$) and a semiconductive material having substantially the same crystal structure and lattice constant as the $Si_{1-x_s} Ge_{x_s}$ alloyed crystal.

17. A bipolar transistor comprising:
a collector layer (31A) made of a semiconductive material other than germanium;
an emitter layer (33) made of a semiconductive material other than germanium; and
a base layer (21) made of germanium, a compressive strain being imposed on the germanium base layer (21).

18. A field effect transistor according to Claim 16, wherein an $Si_{1-x_s} Ge_{x_s}$ layer adjacent to the germanium layer is doped with a p-type impurity to form a modulation-doped field effect transistor.

19. A field effect transistor according to Claim 16, wherein the germanium channel layer (2) is doped with a p-type impurity to form a doped-channel field effect transistor.

20. A bipolar transistor according to Claim 17, wherein the base layer (21) has a heterostructure expressed by $p-Si_{1-x}Ge_x$ (where $0 < x < 1$)/i-Ge.

21. A bipolar transistor according to Claim 17, wherein the germanium base layer (21) is doped with a p-type impurity.

22. A modulation-doped field effect transistor according to Claim 18, wherein the buffer layer (31) is made of an $Si_{1-x_s} Ge_{x_s}$ alloyed crystal, and the alloy ratio $x_s$ of the $Si_{1-x_s} Ge_{x_s}$ alloyed crystal satisfies a relation $0.5 \leq x_s \leq 0.9$.

# F I G. I
## PRIOR ART

320

200

1

P-Si

# F I G. 2A

5

6

4

P⁺     P     P⁺     32

i     2

P     31

n     1

# F I G. 2B

8

9

33     10

21

31A

1

# F I G. 3A

# F I G. 3B

# F I G. 4

P−SiGe    Ge CHANNEL    P−SiGe        Si SUBSTRATE

$\Delta Ev$

# F I G. 5

# F I G. 6

# F I G. 7

# F I G. 8

# F I G. 9A

# F I G. 9B

# F I G. IOA

SILICON CONTENT I-Xs OF BUFFER LAYER

# F I G. IOB

SILICON CONTENT I-Xs OF BUFFER LAYER

# F I G. IOC

# F I G. IOD

# F I G.11

5  4  6

32

22

31

1

# F I G.12A

8

9

331

45

33

2

312

31

10

1

# F I G.12B

9

331

8

45

33

2

87

10

23

87

312

31

1

# F I G . 13

# F I G . 14

BIP TYPE ← ── → ← ── MOD TYPE ──→

# F I G. 15

# F I G. 16

FIG.17A

FIG.17B

FIG.18

EP 0 380 077 A2

FIG.19

FIG.20

FIG.21